(19) Europäisches Patentamt / European Patent Office / Office européen des brevets

(11) **EP 2 786 808 A1**

(12) **EUROPEAN PATENT APPLICATION**
published in accordance with Art. 153(4) EPC

(43) Date of publication:
**08.10.2014 Bulletin 2014/41**

(51) Int Cl.:
*B05D 7/24* (2006.01)     *B05D 3/04* (2006.01)
*B32B 9/00* (2006.01)     *B32B 27/00* (2006.01)
*B32B 27/16* (2006.01)

(21) Application number: **12852991.4**

(22) Date of filing: **28.11.2012**

(86) International application number:
**PCT/JP2012/080736**

(87) International publication number:
**WO 2013/081003 (06.06.2013 Gazette 2013/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.11.2011 JP 2011263129**

(71) Applicant: **Lintec Corporation**
**Tokyo 173-0001 (JP)**

(72) Inventors:
• **IWAYA Wataru**
**Tokyo 173-0001 (JP)**

• **ITO Masaharu**
**Tokyo 173-0001 (JP)**
• **KONDO Takeshi**
**Tokyo 173-0001 (JP)**

(74) Representative: **Beckmann, Claus**
**Kraus & Weisert**
**Patentanwälte PartGmbB**
**Thomas-Wimmer-Ring 15**
**80539 München (DE)**

(54) **MANUFACTURING METHOD FOR GAS BARRIER FILM, AND ELECTRONIC MEMBER OR OPTICAL MEMBER PROVIDED WITH GAS BARRIER FILM**

(57)     The present invention pertains to: a method for producing a gas barrier film that includes at least a base that is formed of a synthetic resin, and a gas barrier layer that is formed on the base, the method comprising a step 1 and 2 below; and an electronic member or an optical member that includes a gas barrier film obtained by the method. In the gas barrier film obtained by means of the present invention, a problem of adhesion failure between the gas barrier layer and the base dose not occur even when the gas barrier film is subjected to high-temperature/high-humidity conditions. [Step 1] that applies a silicon-based polymer compound solution that includes a silicon-based polymer compound and an organic solvent to the base to obtain a film of the silicon-based polymer compound solution, and dries the film by heating to form a layer that includes the silicon-based polymer compound, the base having a gel fraction of 70% or more and less than 98% when immersed in the organic solvent at 23°C for 72 hours; [Step 2] that subjects the layer that includes the silicon-based polymer compound to a plasma treatment to form the gas barrier layer.

Fig. 1

**Description**

TECHNICAL FIELD

The invention relates to a method for producing a gas barrier film that may be used as an electronic device member for a liquid crystal display, an electroluminescence (EL) display, or the like, as well as an electronic member or an optical member that includes the gas barrier film.

BACKGROUND ART

In recent years, use of a transparent plastic film for a display (e.g., liquid crystal display or electroluminescence (EL) display) has been studied in order to implement a display that has a reduced thickness, a reduced weight, and flexibility. However, since a plastic film generally allows water vapor, oxygen, and the like to pass through as compared with a glass substrate, elements provided in a display may easily deteriorate when a transparent plastic film is used as a substrate of a display.

In order to solve the above problem, Patent Document 1 proposes a flexible display substrate in which a transparent gas barrier layer formed of a metal oxide is stacked on the surface of a transparent plastic film using a deposition (evaporation) method, an ion plating method, a sputtering method, or the like. However, since the method disclosed in Patent Document 1 requires large equipment, an increase in cost occurs. Moreover, cracks may occur in the gas barrier layer, and a deterioration in gas barrier capability may occur when the substrate on which the transparent gas barrier layer formed of a metal oxide is stacked is rolled or folded.

In order to solve these problems, Patent Document 2 proposes a method that produces a gas barrier film by forming a polysilazane film on at least one side of a film (base), and subjecting the polysilazane film to a plasma treatment. When using the method disclosed in Patent Document 2, however, a sufficient gas barrier capability cannot be obtained unless the thickness of the gas barrier layer is reduced to a micrometer level. Moreover, delamination may occur at the interface between the polysilazane film and the film (base), and a deterioration in gas barrier capability may occur when the gas barrier film is subjected to high-temperature/high-humidity conditions.

A method that provides a primer layer on a film, a method that produces a functional group on the surface of a film using a corona treatment or a plasma treatment, and the like have been known as a method for improving the interfacial adhesion between a film and a polysilazane film. However, since these methods increase the number of steps, a decrease in productivity and an increase in cost occur.

RELATED-ART DOCUMENT

PATENT DOCUMENT

    Patent Document 1: JP-A-2000-338901
    Patent Document 2: JP-A-2007-237588

SUMMARY OF THE INVENTION

TECHNICAL PROBLEM

The invention was conceived in view of the above situation. An object of the invention is to provide a method for producing a gas barrier film that does not show a deterioration in adhesion between the gas barrier layer and the base even when the gas barrier film is subjected to high-temperature/high-humidity conditions for a long time, and to provide an electronic member or an optical member that includes a gas barrier film obtained by the method.

SOLUTION TO PROBLEM

In order to achieve the above object, the inventors of the invention conducted extensive studies relating to a method for producing a gas barrier film that forms a gas barrier layer on a base. As a result, the inventors found that a gas barrier film that exhibits an excellent gas barrier capability, and does not show a deterioration in adhesion between the gas barrier layer and the base even when the gas barrier film is subjected to high-temperature/high-humidity conditions for a long time, can be obtained by applying a silicon-based polymer compound solution that includes a silicon-based polymer compound and an organic solvent to a base to obtain a film of the silicon-based polymer compound solution, drying the film by heating to form a layer that includes the silicon-based polymer compound, and subjecting the layer that includes the silicon-based polymer compound to a plasma treatment to form the gas barrier layer, the base having a gel fraction of 70% or more and less than 98% when immersed in the organic solvent at 23°C for 72 hours. This finding has led to the completion of the invention.

Several aspects of the invention provide the following method for producing a gas barrier film (see (1) to (6), and electronic member or optical member that includes a gas barrier film obtained by the method (see (7)).

(1) A method for producing a gas barrier film that includes at least a base that is formed of a synthetic resin, and a gas barrier layer that is formed on the base, the method including:

a step 1 that applies a silicon-based polymer compound solution that includes a silicon-based polymer compound and an organic solvent to the base to obtain a film of the silicon-based polymer compound solution, and dries the film by heating to form a layer that includes the silicon-based polymer compound, the base having a gel fraction of 70% or more and less than 98% when immersed in the organic solvent at 23°C for 72 hours; and

a step 2 that subjects the layer that includes the silicon-based polymer compound to a plasma treatment to form the gas barrier layer.

(2) The method according to (1), wherein the plasma treatment performed in the step 2 implants ions into the layer that includes the silicon-based polymer compound.

(3) The method according to (1), wherein the plasma treatment performed in the step 2 implants ions into the layer that includes the silicon-based polymer compound using a plasma ion implantation method.

(4) The method according to (1), wherein the base is formed of an amorphous polymer.

(5) The method according to (1), wherein the base is formed of an amorphous polymer having a glass transition temperature of 100°C or more.

(6) The method according to (1), wherein the silicon-based polymer compound is at least one compound selected from the group consisting of a polysilazane compound, a polycarbosilane compound, a polysilane compound, and a polyorganosiloxane compound.

(7) An electronic member or an optical member including a gas barrier film obtained by the method according to any one of (1) to (6).

ADVANTAGEOUS EFFECTS OF THE INVENTION

The method for producing a gas barrier film according to one aspect of the invention can efficiently produce a gas barrier film that does not show a deterioration in adhesion between the gas barrier layer and the base even when the gas barrier film is subjected to high-temperature/high-humidity conditions for a long time.

Since the electronic member or the optical member according to one aspect of the invention includes a gas barrier film obtained by the method for producing a gas barrier film according to one aspect of the invention, a deterioration in adhesion between the gas barrier layer and the base does not occur even when the electronic member or the optical member is subjected to high-temperature/high-humidity conditions for a long time (i.e., the electronic member or the optical member exhibits excellent durability).

BRIEF DESCRIPTION OF DRAWINGS

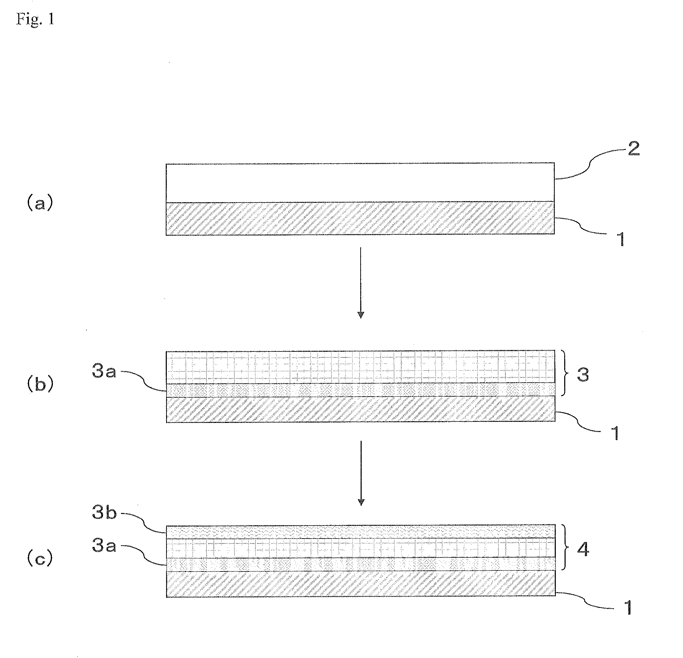

FIG. 1 is a cross-sectional view illustrating a production method according to one embodiment of the invention.

DESCRIPTION OF EMBODIMENTS

A method for producing a gas barrier film, and an electronic member or an optical member that includes a gas barrier film according to several exemplary embodiments of the invention are described in detail below.

1) Method for producing gas barrier film

A method for producing a gas barrier film (hereinafter may be referred to as "production method") according to one embodiment of the invention produces a gas barrier film that includes at least a base that is formed of a synthetic resin, and a gas barrier layer that is formed on the base, the method including: a step 1 that applies a silicon-based polymer compound solution that includes a silicon-based polymer compound and an organic solvent to the base to obtain a film of the silicon-based polymer compound solution, and dries the film by heating to form a layer that includes the silicon-based polymer compound, the base having a gel fraction of 70% or more and less than 98% when immersed in the organic solvent at 23°C for 72 hours; and a step 2 that subjects the layer that includes the silicon-based polymer compound to a plasma treatment to form the gas barrier layer.

Note that the term "film" used herein includes a sheet-like film and a long (belt-like) film. The term "gas barrier" used herein refers to film characteristics that suppress transmission of gas such as oxygen and water vapor.

FIG. 1 is a cross-sectional view illustrating the production method according to one embodiment of the invention (see (a) to (c)). In FIG. 1, reference sign 1 indicates a base, reference sign 2 indicates a film of a silicon-based polymer compound solution, reference sign 3 indicates a layer that includes a silicon-based polymer compound obtained by drying the film 2, reference sign 3a indicates an area that is situated at the interface between the layer 3 and the base 1, and is formed of a mixture of a synthetic resin that forms the base and a silicon-based polymer compound when the surface area of the base 1 is dissolved in an organic solvent, reference sign 3b indicates an area obtained when the surface of the layer that includes a silicon-based polymer compound is modified by a plasma treatment, and reference sign 4 indicates a gas barrier layer.

The step 1 and the step 2 are described in detail below with reference to FIG. 1.

Note that a gas barrier film obtained by the production method according to one embodiment of the invention is not limited to that illustrated in FIG. 1 (see (c)).

Step 1

In the step 1, the silicon-based polymer compound solution that includes the silicon-based polymer compound and the organic solvent is applied to the base to obtain a film of the silicon-based polymer compound solution, and the film is dried by heating to form a layer that includes the silicon-based polymer compound, the base having a gel fraction of 70% or more and less than 98% when immersed in the organic solvent at 23°C for 72 hours.

The base is not particularly limited as long as the base is formed of a synthetic resin, and the synthetic resin that forms the base is moderately dissolved in the organic solvent included in the silicon-based polymer compound solution (i.e., has a gel fraction of 70% or more and less than 98% when immersed in the organic solvent at 23°C for 72 hours). It is preferable that the base be formed of an amorphous polymer from the viewpoint of the above requirement.

Examples of the amorphous polymer include cycloolefin-based polymers such as a polyolefin having a norbornene structure; styrene-based polymers such as polystyrene, a styrene-acrylonitrile copolymer, and a styrene-maleic anhydride copolymer; carbonate-based polymers such as an aromatic polycarbonate and an aliphatic polycarbonate; acrylic-based polymers such as poly(methyl methacrylate); imide-based polymers; polysulfone-based polymers such as polyethersulfone, polysulfone, a modified polysulfone, and polyphenylsulfone; polyphenylene sulfide-based polymers; vinyl alcohol-based polymers; vinyl butyrate-based polymers; vinyl acetal-based polymers; arylate-based polymers; polyoxymethylene-based polymers; mixtures thereof; and the like.

Among these, it is preferable to use a synthetic resin having a glass transition temperature of 100°C or more, more preferably 120°C or more, and particularly preferably 130°C or more, since a gas barrier film that exhibits excellent heat resistance can be obtained.

A synthetic resin having a glass transition temperature of 100°C or more exhibits excellent thermal dimensional stability, and a decrease in adhesion between the gas barrier layer and the base due to thermal shrinkage of the base does not occur even when the gas barrier film is heated.

In particular, cycloolefin-based polymers, carbonate-based polymers, and polysulfone-based polymers are preferable since a gas barrier film that exhibits more excellent heat resistance can be obtained. It is preferable to use a cycloolefin-based polymer (more preferably a polyolefin having a norbornene structure, and particularly preferably a cycloolefin copolymer obtained by copolymerizing norbornene and ethylene) since a gas barrier film that also exhibits excellent transparency can be obtained.

The weight average molecular weight of the synthetic resin is preferably 200 to 1,000,000, and more preferably 1000 to 100,000, from the viewpoint of solubility.

The thickness of the base is not particularly limited, but is normally 0.5 to 500 $\mu$m, and preferably 1 to 100 $\mu$m.

The arithmetic surface roughness (Ra) of the base is preferably 2.0 nm or less. If the arithmetic surface roughness (Ra) of the base exceeds 2.0 nm, the base exhibits adhesion to the layer that includes the silicon-based polymer compound due to an anchor effect, but the surface roughness of the layer that is formed on the base and includes the silicon-based polymer compound increases. Note that the arithmetic surface roughness (Ra) refers to a value measured using an optical interference microscope (measurement area: 10,000 $\mu$m$^2$).

The silicon-based polymer compound (hereinafter may be referred to as "polymer compound") is not particularly limited as long as the silicon-based polymer compound is dissolved in the organic solvent (described later), and modified by the plasma treatment to form the gas barrier layer.

A known compound may be used as the silicon-based polymer compound. Examples of the silicon-based polymer compound include a polysilazane compound, a polycarbosilane compound, a polysilane compound, a polyorganosiloxane compound, and the like (see JP-B-63-16325, JP-A-62-195024, JP-A-63-81122, JP-A-1-138108, JP-A-2-84437, JP-A-2-175726, JP-A-4-63833, JP-A-5-238827, JP-A-5-238827, JP-A-5-345826, JP-A-6-122852, JP-A-6-306329, JP-A-6-299118, JP-A-9-31333, JP-A-10-245436, JP-T-2003-514822, JP-A-2005-36089, JP-A-2008-63586, JP-A-2009-235358, JP-A-2009-286891, JP-A-2010-106100, JP-A-2010-229445, JP-A-2010-232569, JP-A-2010-238736, and WO2011/107018, for example).

Among these, the polysilazane compound is particularly preferable from the viewpoint of gas barrier capability.

The polysilazane compound is not particularly limited. The polysilazane compound may be an inorganic polysilazane or an organic polysilazane. It is preferable to use an inorganic polysilazane from the viewpoint of availability and gas barrier capability. For example, perhydropolysilazane represented by the following formula (1), and an organopolysilazane in which some or all of the hydrogen atoms are substituted with an organic group (e.g., alkyl group), are preferable.

$$H_3Si(NHSiH_2)nNHSiH_3 \qquad (1)$$

wherein n is an arbitrary natural number.

These polysilazane-based compounds may be used either alone or in combination.

A product commercially available as a glass coating material or the like may be used directly as the polysilazane-based compound.

The organic solvent used to prepare the silicon-based polymer compound solution (hereinafter may be referred to as "polymer compound solution") is not particularly limited as long as the organic solvent is a good solvent for the polymer compound, and the base has a gel fraction of 70% or more and less than 98% when immersed in the organic solvent at 23°C for 72 hours. The gel fraction of the base is preferably 85 to 95% from the viewpoint of adhesion and curling suppression capability.

If the gel fraction of the base is 98% or more, the base may be dissolved in the solvent to only a small extent, and the area 3a (described later) may be formed to only a small extent. As a result, excellent adhesion between the base and the gas barrier layer (i.e., the advantageous effect of the invention) may not be achieved. If the gel fraction of the base is less than 70%, the surface of the base may be dissolved to a large extent, and a decrease in transparency may occur, or the base may curl to a large extent. Note that the term "curling" used herein refers to warping of the base that is observed with the naked eye.

The gel fraction may be calculated as described below.

Specifically, the base is cut to have dimensions of 100×100 mm, wrapped with a nylon mesh (#120) (150×150 mm) (of which the mass has been measured in advance), immersed in the organic solvent (100 mL) at 23°C for 72 hours, removed, and dried at 120°C for 1 hour. The mass of the dried base is measured, and the ratio (%) of the measured mass to the mass of the base before immersion is calculated using the following expression, and taken as the gel fraction. The gel fraction is 100% when the base is not dissolved in the organic solvent.

$$\text{Gel fraction (\%)} = [(\text{mass of residual base after immersion}) / (\text{mass of base before immersion})] \times 100$$

When the base has a gel fraction within the above range when immersed in the organic solvent at 23°C for 72 hours, the top surface area of the base is dissolved in the organic solvent to produce a solution of a mixture of the synthetic resin that forms the base and the polymer compound. When the organic solvent is removed by heating (drying), an area formed of a mixture of the synthetic resin that forms the base and the polymer compound is formed at the interface between the base and the layer that includes the polymer compound. This improves adhesion between the base and the gas barrier layer (described later).

The production method according to one embodiment of the invention has an advantage in that it is unnecessary to provide a primer layer or the like between the base and the gas barrier layer in order to improve adhesion between the base and the gas barrier layer, and the process can be simplified.

The organic solvent is selected depending on the type of base and the type of polymer compound. Specific examples of the organic solvent include aromatic-based solvents such as toluene and xylene; ester-based solvents such as ethyl acetate; ester-based solvents such as ethyl acetate; ketone-based solvents such as methyl ethyl ketone; ether-based solvents such as dibutyl ether, ethylene glycol, monobutyl ether, and 1,3-dioxolane; halogenated hydrocarbon-based solvents such as methylene chloride, ethylene chloride, and dichloromethane; aliphatic hydrocarbon-based solvents such as hexane; and the like. These solvents may be used either alone or in combination.

Among these, aromatic-based solvents and ether-based solvents are preferable, and xylene and dibutyl ether are more preferable, since a gel fraction within the preferable range can be obtained, and the polymer compound exhibits excellent solubility.

The polymer compound solution may be prepared by dissolving the polymer compound in the organic solvent.

The solid content (concentration of the polymer compound) in the polymer compound solution is preferably 1 to 60 mass%, more preferably 3 to 45 mass%, and still more preferably 3 to 30 mass%. When the solid content in the polymer compound solution is within the above range, the base can be moderately dissolved, and the solution exhibits excellent applicability due to moderate viscosity.

The polymer compound solution may include an additional component (e.g., dissolution promoter component) as long as the advantageous effects of the invention are not impaired.

The polymer compound solution may be applied to the base using an arbitrary method. For example, a known coating method such as a spin coating method, a spray coating method, a bar coating method, a knife coating method, a roll coating method, a blade coating method, a die coating method, or a gravure coating method may be used.

The film 2 obtained by applying the polymer compound solution to the base 1 (see FIG. 1 (see (a))) is dried by heating to form the layer 3 that includes the polymer compound. In this case, the top surface area of the base is moderately dissolved in the organic solvent to produce a solution of a mixture of the synthetic resin that forms the base and the polymer compound. As illustrated in FIG. 1 (see (b)), the area 3a that is formed of a mixture of the synthetic resin that forms the base and the polymer compound is thus formed at the interface between the base 1 and the layer 3 that includes the polymer compound.

The film 2 may be dried using a known drying method such as hot-air drying or heat roll drying.

The drying temperature may be appropriately selected corresponding to the boiling point of the organic solvent and the type of the synthetic resin that forms the base such that the base is moderately dissolved in the organic solvent. The drying temperature is preferably 100°C to the glass transition temperature (Tg) of the synthetic resin that forms the base. If the drying temperature is less than 100°C, the volatilization rate of the solvent may decrease, and the base may be dissolved to a large extent, and may curl. If the drying temperature exceeds the glass transition temperature (Tg) of the synthetic resin that forms the base, the base may undergo thermal shrinkage. Therefore, the glass transition temperature (Tg) of the synthetic resin that forms the base is preferably 100°C or more.

The drying time is determined taking account of the type of material (base and organic solvent), the drying temperature, and the like. The drying time is normally several seconds to 1 hour, preferably 30 seconds to 15 minutes, and more preferably 30 seconds to 5 minutes.

The area 3a having a nanometer-level thickness and formed of a mixture of the synthetic resin that forms the base and the polymer compound is formed at the interface between the base 1 and the layer 3 that includes the polymer compound by appropriately adjusting the drying temperature and the drying time. As a result, adhesion between the base 1 and the gas barrier layer 4 is improved.

The thickness of the entire layer 3 that includes the polymer compound illustrated in FIG. 1 (see (b)) is not particularly limited, but is normally 20 nm to 10 $\mu$m, preferably 30 nm to 500 nm, and more preferably 40 nm to 200 nm.

Step 2

In the step 2, the layer that includes the silicon-based polymer compound formed by the step 1 is subjected to a plasma treatment to form the gas barrier layer.

The surface of the layer 3 that includes the polymer compound is modified by the plasma treatment to form an area having a gas barrier capability (i.e., the area 3b in which the surface of the layer that includes the polymer compound is modified (see FIG. 1 (see (c))). The term "gas barrier layer" used herein does not refer to only the area 3b in which the surface of the layer that includes the polymer compound is modified by the plasma treatment, but refers to the layer 4 (that includes the polymer compound) that includes the area 3b in which the surface of the layer that includes the polymer compound is modified by the plasma treatment, and the area 3a that is formed of a mixture of the synthetic resin that forms the base and the silicon-based polymer compound.

The plasma treatment may be implemented using a known method. It is preferable to use a method that implants ions into the layer that includes the polymer compound since a gas barrier layer that exhibits an excellent gas barrier capability can be easily formed.

The ions may be implanted using an arbitrary method. For example, the ions may be implanted using a method that applies ions (ion beams) accelerated by an electric field, a method that implants ions present in plasma (plasma ion implantation method), or the like. It is preferable to use the plasma ion implantation method since a gas barrier film can be easily obtained.

The plasma ion implantation method generates plasma in an atmosphere containing a plasma-generating gas, and implants ions (cations) present in the plasma into the target by applying a negative high-voltage pulse to the layer that includes the polymer compound.

It is preferable to use (A) a plasma ion implantation method that implants ions present in plasma generated by utilizing an external electric field into the surface area of the layer that includes the polymer compound, or (B) a plasma ion implantation method that implants ions present in plasma generated due to an electric field produced by applying a negative high-voltage pulse to the layer that includes the polymer compound into the surface area of the layer that includes the polymer compound.

When using the method (A) or (B), the pulse width when applying a negative high-voltage pulse (i.e., during ion implantation) is preferably 1 to 15 $\mu$sec. When the pulse width is within the above range, a transparent and uniform ion-implanted layer can be formed more easily and efficiently.

The voltage applied when generating plasma is preferably -1 to -50 kV, more preferably -1 to -30 kV, and particularly preferably -5 to -20 kV. If the applied voltage is higher than -1 kV, the ion implantation dose may be insufficient, and the desired performance may not be obtained. If the applied voltage is lower than -50 kV, the film may be charged during ion implantation, or coloration or the like may occur.

Examples of the ions to be implanted using the plasma ion implantation method include ions of a rare gas (e.g., argon, helium, neon, krypton, and xenon); ions of a fluorocarbon, hydrogen, nitrogen, oxygen, carbon dioxide, chlorine, fluorine, and sulfur; ions of a metal (e.g., gold, silver, copper, platinum, nickel, palladium, chromium, titanium, molybdenum, niobium, tantalum, tungsten, and aluminum); and the like.

It is preferable to use ions of at least one element selected from the group consisting of hydrogen, nitrogen, oxygen, argon, helium, neon, xenon, and krypton from the viewpoint of ease of implantation and a capability to form a gas barrier layer that exhibits an excellent gas barrier capability and transparency.

The ion implantation dose and the thickness of the ion implantation target area may be appropriately determined taking account of the thickness of the gas barrier layer, the intended use of the gas barrier film, and the like.

The thickness of the ion implantation target area is normally 10 to 1000 nm, and preferably 10 to 200 nm, from the ion implantation target surface. The thickness of the ion implantation target area may be controlled by appropriately determining the type of ions and the implantation conditions (e.g., applied voltage and implantation time).

The gas barrier film obtained by the production method according to one embodiment of the invention exhibits an excellent gas barrier capability. The gas barrier film obtained by the production method according to one embodiment of the invention exhibits an excellent gas barrier capability since the gas barrier film has a low water vapor transmission rate, for example.

The water vapor transmission rate of the gas barrier film at a temperature of 40°C and a relative humidity of 90% is normally 0.5 g/m$^2$/day or less, and preferably 0.1 g/m$^2$/day or less. The water vapor transmission rate may be measured using a known method.

The method for producing a gas barrier film according to one embodiment of the invention may form one gas barrier layer formed of the layer that includes the polymer compound on one side of the base through the step 1 and the step 2, or may form the gas barrier layer on each side of the base through the step 1 and the step 2. The method for producing a gas barrier film according to one embodiment of the invention may include a step that stacks a plurality of gas barrier films, or may include a step that stacks an additional layer other than the base layer and the gas barrier layer. Examples of the additional layer include a protective layer, a conductive layer, a pressure-sensitive adhesive layer, and the like.

Protective layer

The protective layer is a layer that protects the gas barrier layer when an impact is externally applied to the gas barrier layer.

The protective layer may be situated at an arbitrary position. It is preferable that the protective layer be situated adjacent to the gas barrier layer.

It is preferable that the protective layer have high transparency and excellent scratch resistance. When the protective layer is situated on the outermost side when the gas barrier film is incorporated in an electronic device or an optical device, the protective layer may be provided with a stain-proof capability, a fingerprint-proof capability, an antistatic capability, water repellency, hydrophilicity, and the like.

A material for forming the protective layer is not particularly limited.

Examples of the material for forming the protective layer include silicon-containing compounds; polymerizable compositions that include a photopolymerizable compound that includes a photopolymerizable monomer and/or a photopolymerizable prepolymer, and an initiator that generates radicals at least due to light in the visible region; resins such as a polyester resin, a polyurethane resin (particularly a two-component curable resin that includes an isocyanate compound and a polyacryl polyol, a polyester polyol, a polyether polyol, or the like), an acrylic resin, a polycarbonate resin, a vinyl chloride/vinyl acetate copolymer, a polyvinyl butyral resin, and a nitrocellulose resin; alkyl titanates; ethyleneimine; and the like.

These materials may be used either alone or in combination.

A polymerizable composition that includes a photopolymerizable compound that includes a photopolymerizable monomer and/or a photopolymerizable prepolymer, and an initiator that generates radicals at least due to light in the visible region, is preferable as the material for forming the protective layer since excellent transparency and scratch resistance can be achieved.

A known active energy ray-curable compound, a known photoinitiator, and the like may be used as the photopolymerizable compound and the initiator.

The protective layer may be formed by dissolving or dispersing the above material in an appropriate solvent to prepare a protective layer-forming solution, applying the protective layer-forming solution using a known method to form a film, drying the film, and optionally heating the dried film.

The thickness of the protective layer may be appropriately selected taking account of the intended use of the gas barrier film and the like. The thickness of the protective layer is normally 0.05 to 10 $\mu$m, preferably 0.1 to 8 $\mu$m, and still more preferably 0.2 to 5 $\mu$m.

When the thickness of the protective layer is 0.05 $\mu$m or more, the protective layer exhibits sufficient scratch resistance. When the thickness of the protective layer is 10 $\mu$m or less, it is possible to suppress a situation in which the protective layer curls due to strain during curing.

The surface roughness Ra (arithmetic average roughness) of the protective layer is preferably 10.0 nm or less, and more preferably 8.0 nm or less. The surface roughness Rt (maximum roughness height) of the protective layer is preferably 100 nm or less, and more preferably 50 nm or less.

When the surface roughness Ra exceeds 10.0 nm, and/or the surface roughness Rt exceeds 100 nm, the surface roughness of the gas barrier layer may increase, and the gas barrier capability of the gas barrier film may deteriorate.

The surface roughness Ra and the surface roughness Rt refer to values measured by optical interferometry using a sample having dimensions of 100$\times$100 $\mu$m.

Conductive layer

The gas barrier film obtained by the method for producing a gas barrier film according to one embodiment of the invention may include the conductive layer.

The conductive layer is a layer that exhibits electrical conductivity, and is used as an electrode, or used to improve the antistatic capability and the heat dissipation capability when the gas barrier film is included in an electronic member or the like.

The conductive layer may be situated at an arbitrary position selected taking account of the intended use of the gas barrier film.

The surface resistivity of the conductive layer is preferably 1000 $\Omega$/square or less, and more preferably 200 $\Omega$/square or less.

The thickness of the conductive layer may be appropriately selected taking account of the intended use of the gas barrier film and the like. The thickness of the conductive layer is normally 10 nm to 9 $\mu$m, and preferably 20 nm to 1.0 $\mu$m.

Examples of a material for forming the conductive layer include metals, alloys, metal oxides, electrically conductive compounds, mixtures thereof, and the like. Specific examples of the material for forming the conductive layer include antimony-doped tin oxide (ATO); fluorine-doped tin oxide (FTO); metal oxides such as tin oxide, zinc oxide, indium oxide, indium tin oxide (ITO), and indium zinc oxide (IZO); metals such as gold, silver, chromium, and nickel; mixtures thereof; inorganic conductive materials such as copper iodide and copper sulfide; organic conductive materials such as polyaniline, polythiophene, and polypyrrole; and the like.

Among these, metal oxides are preferable, and indium oxide-based metal oxides and zinc oxide-based metal oxides such as zinc oxide, indium oxide, indium tin oxide (ITO), and indium zinc oxide (IZO) are more preferable from the viewpoint of transparency.

The conductive layer may be formed by a deposition (evaporation) method, a sputtering method, an ion plating method, a thermal CVD method, a plasma CVD method, or the like. It is preferable to form the conductive layer using a sputtering method since the conductive layer can be easily formed.

The conductive layer may optionally be patterned. The conductive layer may be patterned by chemical etching (e.g., photolithography), physical etching using a laser or the like, a vacuum deposition method using a mask, a sputtering method using a mask, a lift-off method, a printing method, or the like.

When the gas barrier film obtained by the method for producing a gas barrier film according to one embodiment of the invention includes the additional layer, the position (order) of the additional layer, and the number of additional layers are not particularly limited as long as the above conditions are satisfied.

The gas barrier film that includes the conductive layer and/or the protective layer may have a layer configuration "conductive layer/gas barrier layer/base", "conductive layer/protective layer/gas barrier layer/base", "protective layer/gas barrier layer/base", "protective layer/gas barrier layer/base/gas barrier layer", "protective layer/gas barrier layer/base/gas barrier layer/protective layer", or the like.

Note that the above layer configurations indicate the configuration in a usage state.

Since the gas barrier film obtained by the method for producing a gas barrier film according to one embodiment of the invention exhibits excellent bendability, heat resistance, and humidity resistance, delamination rarely occurs at the interface between the base and the gas barrier layer, and blisters, lifting, and the like rarely occur even when the gas barrier film is exposed to a high temperature/high humidity for a long time.

Since the gas barrier film obtained by the method for producing a gas barrier film according to one embodiment of the invention exhibits an excellent gas barrier capability, and a deterioration in adhesion between the gas barrier layer and the base does not occur even when the gas barrier film is exposed to a high temperature/high humidity, the gas barrier film may preferably be used as a gas barrier film for an electronic member or an optical member. In particular, the gas barrier film may preferably be used as a gas barrier film for an electronic member (e.g., flexible display substrate) for which flexibility is required, or a gas barrier film for an electronic member (e.g., liquid crystal display plastic substrate) for which heat resistance and humidity resistance are required.

2) Electronic member or optical member that includes gas barrier film

An electronic member or an optical member according to one embodiment of the invention includes a gas barrier film obtained by the production method according to one embodiment of the invention.

Examples of the electronic member include flexible substrates such as a liquid crystal display member, an organic EL display member, an inorganic EL display member, an electronic paper member, a solar cell member, and a thermoelectric conversion member.

Examples of the optical member include optical members of an optical filter, a wavelength conversion device, a dimming device, a polarizer, a retardation film, and the like.

Since the electronic member or the optical member according to one embodiment of the invention includes the gas barrier film obtained by the production method according to one embodiment of the invention that is stacked, the electronic member or the optical member exhibits an excellent gas barrier capability, and can prevent entrance of gas (e.g., water vapor).

Moreover, the electronic member or the optical member according to one embodiment of the invention has a reduced weight and thickness, and rarely shows a deterioration in gas barrier capability even when the electronic member or the optical member is used under high-temperature conditions or high-humidity conditions.

EXAMPLES

The invention is further described below by way of examples. Note that the invention is not limited to the following examples.

Example 1

A polymer compound solution that includes perhydropolysilazane (silicon-based polymer compound) and xylene (solvent) ("Aquamika NL110-20" manufactured by Clariant Japan K.K.) was spin-coated onto a cycloolefin copolymer film ("TOPAS 6017" manufactured by Polyplastics Co., Ltd., thickness: 100 $\mu$m, glass transition temperature: 160°C, "COC" in Table 1) (base) so that the thickness after drying was 150 nm, and the resulting film was heated at 120°C for 2 minutes to form a polymer compound layer.

The cycloolefin copolymer film had a gel fraction of 80% when immersed in xylene at 23°C for 72 hours.

Argon (Ar) ions were implanted into the surface of the polymer compound layer under the following conditions using a plasma ion implantation apparatus to produce a gas barrier film 1 in which a gas barrier layer was formed on the base.

Plasma ion implantation conditions
Gas flow rate: 100 sccm
Duty ratio: 0.5%
Repetition frequency: 1000 Hz
Applied voltage: -10 kV
RF power supply: frequency: 13.56 MHz, applied electric power: 1000 W
Chamber internal pressure: 0.2 Pa
Pulse width: 5 $\mu$sec
Processing time (ion implantation time): 5 min

Feeding speed: 0.2 m/min

Examples 2 to 5

Gas barrier films 2 to 5 of Examples 2 to 5 in which a gas barrier layer was formed on a base were produced in the same manner as in Example 1, except that the base and the solvent shown in Table 1 were used.
Note that the abbreviations in Table 1 have the following meanings.
PC: polycarbonate resin film ("Pure-Ace" manufactured by Teijin Chemicals Ltd., thickness: 100 $\mu$m, glass transition temperature: 145°C)
PSF: polysulfone-based resin film ("ULTRASON S3010" manufactured by BASF, thickness: 55 $\mu$m, glass transition temperature: 187°C)
PVAC: polyvinyl acetal resin film ("S-LEC KS-10" manufactured by Sekisui Chemical Co., Ltd., thickness: 20 $\mu$m, glass transition temperature: 110°C)

Comparative Example 1

A gas barrier film 1r of Comparative Example 1 was produced in the same manner as in Example 1, except that a polyethylene terephthalate film ("PET 50A-4100" manufactured by Toyobo Co., Ltd., thickness: 50 $\mu$m, glass transition temperature: 80°C, "PET" in Table 1) was used as the base.

Comparative Example 2

A gas barrier film 2r of Comparative Example 2 in which a gas barrier layer was formed on a base was produced in the same manner as in Example 1, except that the base and the solvent shown in Table 1 were used.
The type and the thickness of the base, and the diluting solvent for the silicon-based polymer compound used in Examples 1 to 5 and Comparative Examples 1 and 2 are shown in Table 1.

Performance confirmation tests using gas barrier film

The gas barrier films 1 to 5 obtained in Examples 1 to 5 and the gas barrier films 1f and 2r obtained in Comparative Examples 1 and 2 were subjected to measurement of the water vapor transmission rate and an interlayer adhesion evaluation test using the following methods. The results are shown in Table 1.

Measurement of water vapor transmission rate

The water vapor transmission rate of the gas barrier film was measured using a water vapor transmission rate measurement apparatus ("PERMATRAN-W3/33" manufactured by MOCON) at a temperature of 40°C and a relative humidity of 90%.

Interlayer adhesion evaluation test

The gas barrier film was allowed to stand under high-temperature/high-humidity conditions (temperature: 60°C, humidity: 90%) for 150 hours, and delamination of the film was observed in accordance with a cross-cut adhesion test (JIS K-5400 (1990)). A case where the number of squares in which delamination of the film was observed was less than 10% of the total number of squares (100 squares) was evaluated as "Acceptable", and a case where the number of squares in which delamination of the film was observed was 10% or more of the total number of squares (100 squares) was evaluated as "Unacceptable".

TABLE 1

| | Gas barrier film | Base | Tg of base (°C) | Thickness of base ($\mu$m) | Diluting solvent for silicon-based polymer compound | Interlayer adhesion | Gel fraction (%) | Water vapor transmission rate (g/m$^2$/day) |
|---|---|---|---|---|---|---|---|---|
| Example 1 | 1 | COC | 160 | 100 | Xylene | Acceptable | 80 | 0.04 |
| Example 2 | 2 | COC | 160 | 100 | Dibutyl ether | Acceptable | 90 | 0.04 |
| Example 3 | 3 | PC | 145 | 100 | Xylene | Acceptable | 86 | 0.04 |
| Example 4 | 4 | PSF | 187 | 55 | Xylene | Acceptable | 90 | 0.04 |
| Example 5 | 5 | PVAC | 110 | 20 | Xylene | Acceptable | 80 | 0.04 |
| Comparative Example 1 | 1r | PET | 80 | 50 | Xylene | Unacceptable | 100 | 0.02 |
| Comparative Example 2 | 2r | PC | 145 | 100 | Dibutyl ether | Unacceptable | 100 | 0.04 |

EP 2 786 808 A1

As shown in Table 1, the gas barrier films 1 to 5 obtained in Examples 1 to 5 showed excellent adhesion between the base and the gas barrier layer as compared with the gas barrier films obtained in Comparative Examples 1 and 2 that were produced using the base formed of a synthetic resin having a gel fraction of more than 98% when immersed in the organic solvent.

In particular, no curling was observed with the naked eye for the gas barrier films obtained in Examples 2 and 4 that were produced using the base formed of a synthetic resin having a gel fraction of 90% when immersed in the organic solvent. Specifically, the gas barrier films obtained in Examples 2 and 4 exhibited particularly excellent performance.

REFERENCE SIGNS LIST

1   Base
2   Film of polymer compound solution
3   Layer that includes polymer compound
3a  Area formed of mixture of synthetic resin that forms base and polymer compound
3b  Area in which surface of layer that includes polymer compound is modified by plasma treatment
4   Gas barrier layer

**Claims**

1. A method for producing a gas barrier film that includes at least a base that is formed of a synthetic resin, and a gas barrier layer that is formed on the base, the method comprising:

   a step 1 that applies a silicon-based polymer compound solution that includes a silicon-based polymer compound and an organic solvent to the base to obtain a film of the silicon-based polymer compound solution, and dries the film by heating to form a layer that includes the silicon-based polymer compound, the base having a gel fraction of 70% or more and less than 98% when immersed in the organic solvent at 23°C for 72 hours; and
   a step 2 that subjects the layer that includes the silicon-based polymer compound to a plasma treatment to form the gas barrier layer.

2. The method according to claim 1, wherein the plasma treatment performed in the step 2 implants ions into the layer that includes the silicon-based polymer compound.

3. The method according to claim 1, wherein the plasma treatment performed in the step 2 implants ions into the layer that includes the silicon-based polymer compound using a plasma ion implantation method.

4. The method according to claim 1, wherein the base is formed of an amorphous polymer.

5. The method according to claim 1, wherein the base is formed of an amorphous polymer having a glass transition temperature of 100°C or more.

6. The method according to claim 1, wherein the silicon-based polymer compound is at least one compound selected from a group consisting of a polysilazane compound, a polycarbosilane compound, a polysilane compound, and a polyorganosiloxane compound.

7. An electronic member or an optical member comprising a gas barrier film obtained by the method according to any one of claims 1 to 6.

Fig. 1

(a)

2

1

(b)

3a

3

1

(c)

3b

3a

4

1

**INTERNATIONAL SEARCH REPORT**

| International application No. |
| --- |
| PCT/JP2012/080736 |

A.   CLASSIFICATION OF SUBJECT MATTER
*B05D7/24*(2006.01)i, *B05D3/04*(2006.01)i, *B32B9/00*(2006.01)i, *B32B27/00* (2006.01)i, *B32B27/16*(2006.01)i

According to International Patent Classification (IPC) or to both national classification and IPC

B.   FIELDS SEARCHED

Minimum documentation searched (classification system followed by classification symbols)
B05D1/00-7/26, B32B1/00-43/00

Documentation searched other than minimum documentation to the extent that such documents are included in the fields searched
Jitsuyo Shinan Koho          1922-1996    Jitsuyo Shinan Toroku Koho    1996-2013
Kokai Jitsuyo Shinan Koho    1971-2013    Toroku Jitsuyo Shinan Koho    1994-2013

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| Y | WO 2011/043315 A1  (Konica Minolta Holdings, Inc.), 14 April 2011 (14.04.2011), claims; paragraphs [0038] to [0145], [0191] to [0194]; examples (Family: none) | 1-7 |
| Y | JP 2007-237588 A  (Kyodo Printing Co., Ltd.), 20 September 2007 (20.09.2007), claims; paragraphs [0012] to [0025]; examples (Family: none) | 1-7 |

☒   Further documents are listed in the continuation of Box C.          ☐   See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 22 February, 2013 (22.02.13) | 05 March, 2013 (05.03.13) |

| Name and mailing address of the ISA/ Japanese Patent Office | Authorized officer |
| --- | --- |
| Facsimile No. | Telephone No. |

Form PCT/ISA/210 (second sheet) (July 2009)

**INTERNATIONAL SEARCH REPORT**

| International application No. |
|---|
| PCT/JP2012/080736 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 56-862 A (General Electric Co.), 07 January 1981 (07.01.1981), claims; page 4, upper right column, line 14 to lower left column, line 1; page 7, lower right column, line 2 to page 8, upper right column, line 2; examples<br>& AU 5323679 A          & AU 5750080 A<br>& AU 6415680 A          & AU 523937 B<br>& BE 882993 A           & BR 7907842 A<br>& CA 1159978 A          & CA 1164118 A<br>& DE 2947879 A          & DE 3016021 A<br>& DE 3041297 A          & DK 178880 A<br>& ES 490941 A           & ES 496394 A<br>& FR 2442879 A          & FR 2455071 A<br>& FR 2468631 A          & GB 2036771 A<br>& GB 2048291 A          & GB 2062662 A<br>& IT 1141087 B          & IT 1141493 B<br>& IT 8021615 D0         & JP 55-94972 A<br>& JP 56-88469 A         & KR 10-1984-0000216 B1<br>& KR 10-1984-0000610 B1 & KR 10-1984-0001762 B1<br>& NL 8002430 A          & NO 801188 A<br>& SE 8003171 A          & SE 8007782 A<br>& US 4277287 A          & US 4299746 A<br>& US 4308315 A          & US 4324839 A<br>& US 4368236 A          & US 4413088 A<br>& US 4477528 A | 1-7 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000338901 A
- JP 2007237588 A
- JP 63016325 B
- JP 62195024 A
- JP 63081122 A
- JP 1138108 A
- JP 2084437 A
- JP 2175726 A
- JP 4063833 A
- JP 5238827 A
- JP 5345826 A
- JP 6122852 A
- JP 6306329 A
- JP 6299118 A
- JP 9031333 A
- JP 10245436 A
- JP 2003514822 T
- JP 2005036089 A
- JP 2008063586 A
- JP 2009235358 A
- JP 2009286891 A
- JP 2010106100 A
- JP 2010229445 A
- JP 2010232569 A
- JP 2010238736 A
- WO 2011107018 A